# EUROPEAN PATENT SPECIFICATION

(11) **EP 1 843 403 B1**
(45) Date of publication and mention of the grant of the patent: **28.12.2016**
(21) Application number: 07105251.8
(22) Date of filing: 29.03.2007
(51) Int. Cl.: H01L 33/00, G02B 6/42, H01L 25/075, H04N 1/028, H05K 1/18, H05K 3/30

(54) **Light emitting unit and lighting apparatus**
Lichtemittierender Baustein und Beleuchtungsvorrichtung
Elément électroluminescent et appareil d'éclairage

(30) Priority: 03.04.2006 JP 2006101516; 06.04.2006 JP 2006104977
(43) Date of publication of application: 10.10.2007
(73) Proprietor: Nichia Corporation, Anan-shi Tokushima 774-8601 (JP)
(72) Inventor: Sumitani, Naofumi, Anan-shi, Tokushima 774-8601 (JP)
(74) Representative: Fenlon, Christine Lesley

(56) References cited:
- JP-A- H1 117 231
- JP-A- 2005 217 644
- JP-A- 2005 229 647
- US-A1- 2002 004 251
- US-A1- 2005 150 956
- US-A1- 2005 206 800
- US-A1- 2005 276 064
- US-A1- 2005 280 017

## Description

### BACKGROUND OF THE INVENTION

### 1. Field of the Invention

The present invention relates to a light emitting unit and to a lighting apparatus in which this light emitting unit is mounted.

### 2. Background Information

Image sensors and other such image scanner devices are used as devices for reading documents in facsimile machines, copiers, hand scanners, and other such devices. Usually, these image readers are contact image sensors which have a short optical path length and are easy to incorporate into devices.

A contact image sensor uses a lighting apparatus to emit light of at least a readable illuminance onto part of the document to be read, and in recent years a line lighting apparatus or the like having a light emitting diode disposed at the end of a rod-shaped light guide has been used to perform reading (see, for example, Japanese Laid-Open Patent Application 2005-217644).

As shown in FIG. 4, the line lighting apparatus 40 used in this document reading apparatus is configured such that a light guide 41 is mounted in a white case 42 with its emitting face 41a exposed, a light emitting unit 43 having a light emitting diode (LED) is disposed at both ends of the case 42, the light emitted by the LED is emitted from the emitting face 41 a, and this light can be emitted on the surface of a document or the like. The light emitting units 43 used here usually each have an LED mounted, and are each comprised of a package 44 formed substantially in a plate shape and a lead terminal 45 protruding from the side face of the package 44. This light emitting unit 43 is electrically connected to a circuit board 46 of the line lighting apparatus 40 by fitting the lead terminal 45, which allows light to be emitted.

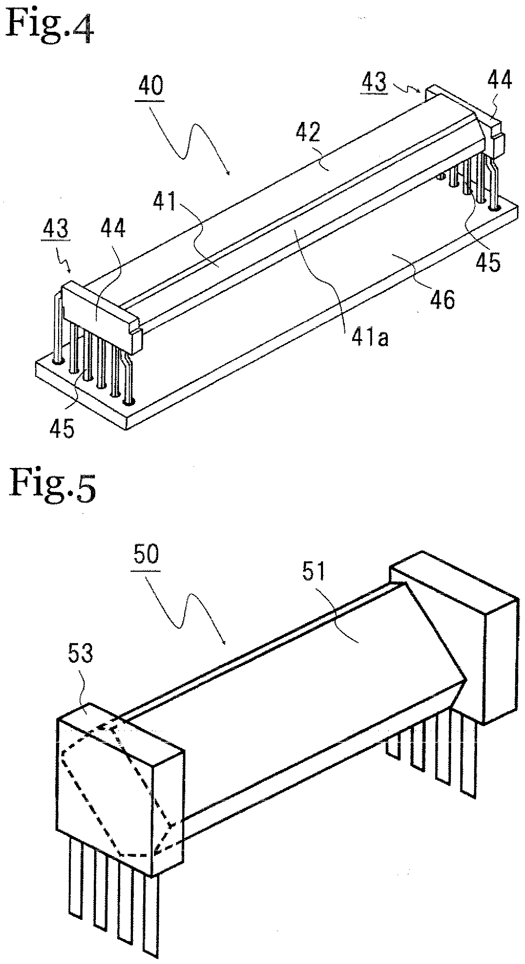

Also, there is a configuration in which, as shown in FIG. 5, for example, a line lighting apparatus 50 having a light guide 51, a light emitting unit 53, and so forth is mounted at an angle to a circuit board (not shown) in order to prevent shadows and the like even if there are creases in the document paper, differences in height where papers have been stuck together, or the like, or to make the optical intensity distribution more uniform over the illuminated surface (see, for example, Japanese Laid-Open Patent Application 2005-229647).

A configuration is known (for example from US2005/0206800A1, US2005/0150956A1, and US2005/0276064A1) in which light emitting diodes mounted in a package are exposed through a light emitting window in the package which is inclined at an angle with respect to a face of the package through which lead terminals extend perpendicularly with respect to the face.

Another configuration is known (for example from US2002/004251A1) in which lead frames protruding perpendicularly from the package are bent along their lengths.

A line lighting apparatus is ordinarily mounted inside a document reader along with various electronic parts. Therefore, it will be even more necessary in the future that a variety of usage modes can be accommodated, and that the various electronic parts can fulfill their respective functions while affording reductions in size and weight.

### SUMMARY OF THE INVENTION

Accordingly, it is desirable to provide a light emitting unit and lighting apparatus with which conventional functions can be maintained while various other requirements can also be met.

A first aspect of the present invention provides a light emitting unit, comprising:
a light emitting element;
a plurality of lead frames to which said light emitting element is electrically connected, each lead frame having a first terminal with a distal end for insertion into a circuit board; and
a package in which said lead frames are inserted so that at least the first terminal of each lead frame protrudes from a bottom side face of the package, and on which a light emitting window is arranged through which light from the light emitting element is emitted,
the light emitting unit being of a type configured to emit light from the light emitting window in a direction which is substantially parallel to the plane of the circuit board into which the distal ends of the first terminals are to be inserted;
wherein:
   at least the distal end of each first terminal is inclined with respect to a side of the light emitting window; and
   at least the distal end of each first terminal is also inclined with respect to the said bottom side face of the package from which the first terminals protrude.

Further, an embodiment of a second aspect of the present invention provides a lighting apparatus, comprising:
the light emitting unit according to the above;
a circuit board into which the first terminals of the lead frames are inserted; and
a light guide plate that is disposed substantially parallel with the circuit board and to one or both ends of which the light emitting window is fixed.

With a light emitting unit and lighting apparatus embodying the present invention, at least the ends of the lead terminals are extended in an angled direction, so only the minimum amount of space required to achieve the original function thereof can be ensured, which keeps dead space to a minimum. Accordingly, other electronic parts can be disposed closer, and an apparatus that is smaller and lighter in weight can be obtained.

A light emitting unit embodying the present invention can be utilized not only in lighting apparatus used for image readers in facsimile machines, copiers, hand scanners, and so forth in which light emitting elements are mounted, but also in illumination light sources, LED displays, backlight light sources for mobile phones and the like, signaling devices, lighted switches, vehicle brake lamps, various sensors, various indicators, and various other types of lighting apparatus.

### BRIEF DESCRIPTION OF THE DRAWINGS

FIG. 1 is a simplified plan view of the main components, for illustrating a light emitting unit embodying the present invention;
FIG. 2 is a simplified plan view of the main components, for illustrating another light emitting unit embodying the present invention;
FIG. 3 a simplified plan view of the main components, for illustrating yet another light emitting unit embodying the present invention;
FIG. 4 is a simplified oblique view of the main components, for illustrating a previously-proposed lighting apparatus; and
FIG. 5 is a simplified oblique view of the main components, for illustrating another previously-proposed lighting apparatus.

### DETAILED DESCRIPTION OF THE PREFERRED EMBODIMENTS

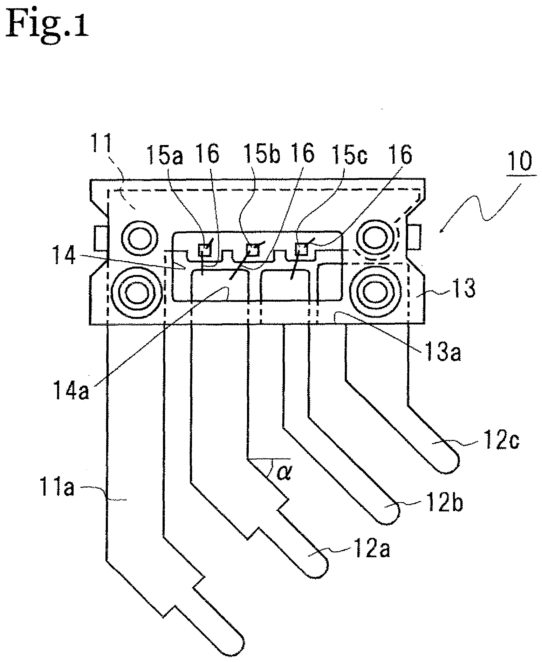

As shown in FIG. 1, for example, a light emitting unit embodying the present invention comprises light emitting elements 15a, 15b, and 15c, lead frames 11, 12a, 12b, and 12c, and a package 13.

The lead frames are electrodes used for electrically connecting to the light emitting elements, and may be substantially flat, or may be undulating, or may be in the form of a bumpy sheet. There are no particular restrictions on the material, but forming the lead frames from a material with a relatively high thermal conductivity is preferable. Forming from such a material allows the heat generated by the light emitting elements to release more efficiently. For example, it is preferable to use a material that has a thermal conductivity of about 200 W/(m·K) or higher, or one with a relatively high mechanical strength, or one that lends itself well to punching, etching, or other such process. More specifically, examples include copper, aluminum, gold, silver, tungsten, iron, nickel, and other such metals, and alloys such as iron-nickel or phosphor bronze. The size, thickness, shape, and so forth of the lead frames can be suitably adjusted after taking into account the size, shape, and so forth of the light emitting device to be obtained.

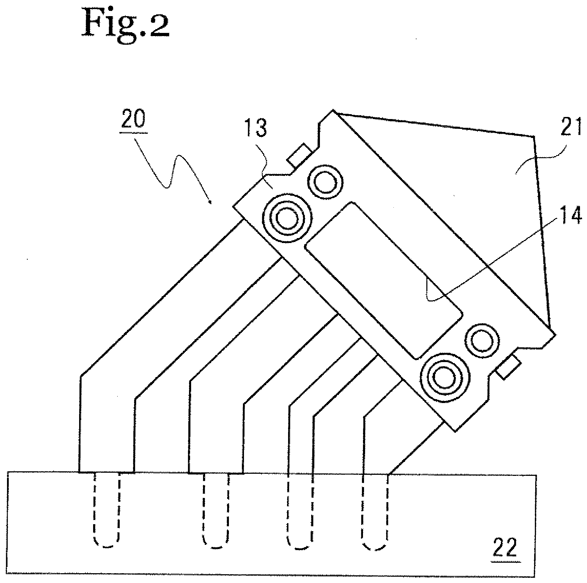

The lead frames have an area where light emitting elements are disposed inside the package, one end used for external connection and protruding from one side or face of the package (hereinafter also referred to as "first terminal" or "lead terminal"), and, optionally, an extension. The other end (hereinafter also referred to as "second terminal") may protrude from a different portion of the package (such as the opposite side) from the face or side from which the first terminal protrudes (see 21 in FIG. 2). This second terminal is preferably expanded to have a larger surface area than the first terminal. This improves heat radiation. There are no particular restrictions on the size and shape of the first and second terminals, which can be suitably adjusted, for example, by taking into account the high heat radiation of the light emitting elements mounted in the light emitting unit, and how the light emitting unit is to be used (such as the space and location where it is to be mounted), as long as these terminals extend to outside the package (discussed below). The extension and the expanded terminal can be suitably bent or deformed according to the positional relationship with the other electronic devices and so forth according to the intended usage mode.

The package is used for protecting the light emitting elements and forming integrally with the lead frames, and may be formed of any material as long as a resin which molds electronic component such as a semiconductor element and a light emitting element. Preferably, the package has insulation, and is formed by a material which is good heat radiation performance, for instance, thermoplastic resins, thermosetting resins, and so forth. There are no particular restrictions on the shape of the package, and the shape in plan view may, for example, be triangular, quadrilateral, polygonal, and shapes that are close to these. In particularly, the package preferably has a shape in plan view of quadrilateral or nearly quadrilateral. A cuboid shape, or a shape close thereto, is especially favorable, and a thin plate form is particularly good. This minimizes the dead space that occurs in mounting on a circuit board.

A light emitting window is formed in the package. The light emitting window is usually formed on the widest side of the package. In other words, it is formed on a different face from the package surface from which the lead terminal (discussed below) protrudes, such as a face that is substantially perpendicular to the direction in which the lead terminal extends. "substantially" perpendicular as used here means not only perpendicular in the strict sense, and an angle of about ±5° is permitted.

The light emitting window is a place where the package is open in that area of the lead frames embedded in the package where the light emitting elements are mounted, and that area of the lead frames embedded in the package where the electrodes of the light emitting elements are connected, and is a window that allows these areas to be exposed. As a result, light from the light emitting elements is reflected by the inner walls of the package and can be taken out toward the front more efficiently. Therefore, there are no particular restrictions on the size and shape of the light emitting window as long as the window is large enough for the light emitting elements to be mounted and electrically connected. The shape of the light emitting window can be variously selected according to the desired light emission characteristics, but examples include circular, elliptical, triangular, quadrilateral, polygonal, and shapes that are close to these.

When the light emitting window is shaped as above, one side of the molded package is preferably parallel or perpendicular to one side of the light emitting window (with a triangular shape, for instance, the bottom side, and with a quadrilateral shape, the bottom side or a lateral side). It is particularly favorable for one side of the light emitting window to be parallel or perpendicular to one side of the any of all of the sides when the shape of the molded package is a parallelepiped or a shape close to that. This makes it easier to adjust the positional relationship between the package and the light emitting window. It is especially favorable for the package to be a parallelepiped or substantially a parallelepiped, the light emitting window to be quadrilateral or substantially quadrilateral, and one side of the parallelepiped to be disposed parallel to one side of the quadrangle.

The first terminals of the lead frames are portion that function as terminals used to supply electrical power to the light emitting elements mounted on the lead frames, and extend in substantially the same or a substantially parallel planar shape as that of the lead frames. As a result, a light emitting unit embodying the present invention emits light substantially parallel to the circuit board plane (horizontal) when the first terminals are inserted into the interconnecting holes in the circuit board. The phrase "extend in substantially the same planar shape" as used here means that the first terminals of the lead frames extend such that the plane extending from the front or back side of the lead frame surface coincides with the plane extending from the front or back side of the first terminals of the lead frames. The phrase "extend in a substantially parallel planar shape" as used here means that the first terminals of the lead frames extend such that the plane extending from the front or back side of the lead frame surface is parallel or substantially parallel to (eg, an angle of about ±5° is permitted) the plane extending from the front or back side of the first terminals of the lead frames.

With an embodiment of the present invention, the number of first terminals of the lead frames can be increased or decreased according to the number of light emitting elements mounted in the light emitting unit. One or more can be provided; for example, in the independent drive of RGB, there can be a single common terminal and three independent terminals.

There are no particular restrictions on the material, shape, size, thickness, etc., of the lead frame terminals, but the material and so forth must allow the appropriate amount of power to be supplied to the light emitting elements.

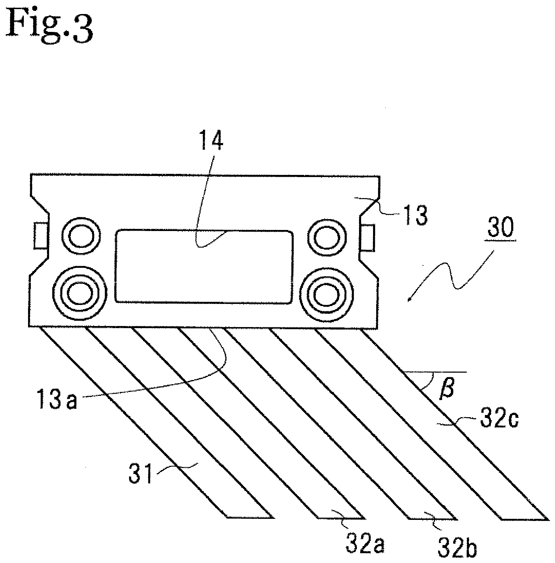

The terminals of the lead frames protrude from the side face of the package, and at least the distal ends thereof extend at an angle to one or both sides of the light emitting window and one face of the above-mentioned package (the surface from which the lead terminals protrude). The phrase "at an angle" here means that the terminals of the lead frames are angled/bent while maintaining their extension in substantially the same plane. There are no particular restrictions on the degree of this angle, as long as the angle is large enough for the light emitting window of the light emitting unit to fit into the desired space when the light emitting unit is mounted on a circuit board. For example, this angle may be within a range of less than ±90° (such as α in FIG. 1 or β in FIG. 3), and about 30 to 60°, or -30 to -60°, is suitable. The terminals of the lead frames may be angled not at just the distal end portion, that is, may be angled over the entire length of the portion protruding from the package, but when the angled portion is at the distal end, the package portion of the light emitting unit can be kept the proper distance away from the circuit board during mounting, and this reduces thermal degradation of the package portion.

The light emitting elements are generally semiconductor light emitting elements, especially, any semiconductor light emitting elements may be used so long as they are elements called light emitting diodes. For example, it includes a laminated structure that contains an active layer above a substrate, which is made of nitride semiconductors such as InN, AIN, GaN, InGaN, AlGaN, and InGaAlN, and compound semiconductors of a group III-V elements, II-VI elements, and the like. The structures of semiconductor includes homostructures having MIS junctions, PIN junctions, or PN junctions or the like, heterostructures, and double heterostructures. Furthermore, a single quantum well structure or a multiquantum well structure laminated as a thin film which generates quantum effects is also acceptable. The active layer may contain a donor impurity such as Si, Ge, or the like, and acceptor impurity such as Zn, Mg, or the like. A wave length of the obtained light emitting element may be changed from ultraviolet to red region depending on a material of the semiconductor, a mixed crystal rate, In content of the active layer, kind of the impurity doped in the active layer.

The light emitting elements are mounted on the lead frames (discussed below), and a joining material is used for this purpose. For instance, in the case of light emitting elements formed by growing a nitride semiconductor on a sapphire substrate, that emit blue and green light, an epoxy resin, silicone, or the like can be used. When degradation due to light or heat from the light emitting elements is taken into account, the back side of the light emitting elements may be plated with aluminum, or instead of using a resin, a solder such as eutectic Au-Sn, or a brazing material such as a low-melting point metal may be used. In the case of a light emitting element with electrodes formed on both sides, such as a light emitting element that is formed by GaAs, or the like and emits red light, die bonding may be performed using a conductive paste made of silver, gold, palladium, or the like.

A light emitting device embodying the present invention may comprise just one light emitting element, or a plurality of them may be mounted. In the latter case, a plurality of light emitting elements that emit light of the same color may be combined. Color reproduction can be enhanced by combining a plurality of light emitting elements that emit light of different colors, so as to handle RBG, for instance.

A light emitting unit embodying the present invention may have one or more windows like the light emitting window formed in a specific location of the package, such as the same face where the light emitting window is formed, so that the light emitting elements and protective elements can be mounted through the side face of the window. This window is preferably formed in a size, shape, and location such that a specific area of the lead terminals will be exposed so that protective elements can be electrically connected to the lead terminals. Also, the windows in the light emitting unit are preferably filled in with a protective resin after the light emitting elements or protective elements have been electrically connected to the lead frames. Furthermore, the windows through which the protective elements are mounted may be filled in with the same material as the package and the protective elements embedded inside the package. Providing protective elements in this way effectively prevents damage to the light emitting elements by the application of a large current, for example. A protective element mounted in the light emitting device of the present invention may be just one, or two or more. There are no particular restrictions on the protective element, and any known type that is mounted in light emitting devices may be used. Specific examples include elements that protect against overheating, over-voltage, over-current, and static electricity, and circuit protection elements.

With a light emitting device embodying the present invention, the opening in which the light emitting element is located is preferably filled with a translucent covering material. This translucent covering material protects the light emitting element from external force, moisture, and so forth, and also protects wires. Examples of this translucent covering material include epoxy resin, silicone, acrylic resin, urea resin, and other transparent resins, glass, and so forth with excellent weather resistance. In particular, even if moisture should be admixed into the translucent covering material during manufacture or storage, any moisture contained in the transparent resin can be released to the outside by baking for at least 14 hours at 100°C. Therefore, it is possible to prevent separation between the light emitting element and a molding member, and steam explosion.

The translucent covering material may contain a diffuser or a fluorescent substance. A diffuser is an agent that diffuses light, and serves to wide directionality from the light emitting element and to widen the viewing angle. A fluorescent substance is one that converts light from the light emitting element, and is able to convert the wavelength of light emitted from the light emitting element to the outside of the package. If the light from the light emitting element is visible light with a short wavelength and high energy, then it is favorable to use an inorganic phosphor material such as ZnCdS:Cu, YAG:Ce, or nitrogen-containing CaO-Al₂O₃-SiO₂ that has been activated with europium and/or chromium, or a perylene derivative, which is an organic phosphor material. With the present invention, when white light is to be obtained, particularly when a YAG:Ce phosphor material is used, depending on the content thereof, it is possible to emit yellow light that absorbs part of, and is a complement to, the light from a blue light emitting element, and white light can be formed relatively simply and with good reliability. Similarly, when nitrogen-containing CaO-Al₂O₃-SiO₂ that has been activated with europium and/or chromium is used, depending on the content thereof, it is possible to emit green light and red light that absorb part of, and are complement to, the light from a blue light emitting element, and white light LED can be formed relatively simply and with good reliability. Also, color unevenness can be reduced by completely precipitating the phosphor material and removing bubbles.

A lighting apparatus embodying the present invention has a light emitting unit embodying the present invention disposed at one or both ends of a rod-shaped or plate-shaped light guide, and can be used, for example, in a line lighting apparatus of an image reader. This lighting apparatus may have substantially the same constitution as those discussed in Japanese Laid-Open Patent Applications 2003-23525 and 2005-229647 and elsewhere.

More specifically, the lighting apparatus has a light guide mounted in a light guide case so that the emitting face is exposed, and has the above-mentioned light emitting unit, in which light emitting elements are mounted, disposed at one or both ends of the light guide case so that light will be incident.

The light guide is usually formed from a translucent material composed of glass or a plastic such as acrylic. Particularly when the distance between the ends is far, such as when the light guide is in the form of a parallelepiped or a cylinder, it is preferable to form a light-scattering pattern by coating with a light scattering agent or by embossing, on the face across from the light emitting face of the light guide. The result of this is that light coming in from one or both ends of the light guide is repeatedly scattered, allowing the light to be emitted more uniformly from the entire emitting face.

This lighting apparatus is usually mounted by inserting the terminals protruding from the light emitting unit into interconnecting holes in the circuit board, and soldering. With a light emitting unit embodying the present invention discussed above, the package and the light emitting window are located substantially in parallel, and at least the distal ends of the terminals of the lead frames are at an angle to the light emitting window of the light emitting unit, so the molded article of the package can be disposed on one or both ends in a shape that substantially corresponds to or matches the shape of the light guide side face, and in mounting on a circuit board, the light guide can be angled so that the molded article of the package is offset in the desired direction. As a result, dead space can be kept to a minimum and the lighting apparatus can be assembled with various electronic devices located closer, which allows an apparatus in which this lighting apparatus is mounted to be smaller and lighter in weight.

Examples of the light emitting unit and lighting apparatus embodying the present invention will now be described in detail through reference to the drawings.

### Example 1

As shown in FIG. 1, the light emitting unit 10 in this example comprises a lead frame 11 on which light emitting elements are placed and which is electrically connected by wire to one of the electrodes of the light emitting elements, three lead frames 12a, 12b, and 12c electrically connected by wires to the other electrodes of the light emitting elements, and a package 13 that integrally fixes the above components.

The lead frames 11, 12a, 12b, and 12c are in the form of plates composed of an iron-containing alloy of copper. The lead frame 11 comprises an area where the light emitting elements are placed, and an extension 11a that extends in one direction from said area. The surface of the lead frame 11 is preferably given a reflective plating so that the light from the light emitting elements becomes luminous more efficiently, and silver plating is performed in this example.

The planes in which the lead frames 11, 12a, 12b, and 12c are formed extend so as to constitute substantially the same plane, and the terminal distal ends of the lead frames 12a, 12b, and 12c are bent at an angle α of 30° with respect to the bottom face 13a of the package 13 (discussed below).

The package 13 integrally fixes the lead frames 11, 12a, 12b, and 12c so that first terminals of each protrude, and has a shape that is close to that of a parallelepiped (10 × 5 × 1 mm). Near the center of the molded article is formed a light emitting window 14 that is substantially rectangular in shape (3 × 2 mm). The bottom face 14a of the light emitting window 14 is disposed parallel to the bottom face 13a of the molded article of the package 13. Parts of the lead frames 11, 12a, 12b, and 12c are exposed within the light emitting window 14. The three lead frames 12a, 12b, and 12c are cathodes, and the lead frame 11 is anode. The lead frame 11 that is opposite to the lead frames 12a, 12b, and 12c inside the light emitting window has thereon three light emitting elements 15a, 15b, and 15c so as to position parallel to the bottom face 13a of the molded article, and corresponding to RGB. The electrodes of the light emitting elements 15a, 15b, and 15c are electrically connected by wires 16 to the lead frames 11, 12a, 12b, and 12c.

Although not depicted in the drawings, this light emitting unit 10 has a protective element electrically connected to the lead frame 12a inside the package 13.

With this light emitting unit, the lead terminals are inserted into and fixed in the interconnecting holes in a circuit board, which allows the light emitting window of the light emitting unit to be offset according to the angle α of inclination of the lead terminals. This ensures the desired amount of space at the desired location, and affords greater latitude in combining with other electronic devices. In addition, other electronic devices can be disposed closer to the light emitting unit, and this reduces the size and weight of the apparatus and increases its output.

### Example 2

As shown in FIG. 2, the light emitting unit 20 in this example has substantially the same constitution as the light emitting unit of Example 1, except that a second terminal 21 of the lead frame 11 on which the light emitting elements are placed protrudes from the package side face on the opposite side from the first terminals in a resin-sealed molded article, and this second terminal 21 is expanded to a larger surface area than that of the first terminals.

With this light emitting unit, heat generated by the light emitting elements can be guided through the lead frames to the outside of the package, and efficiently released by the expanded second terminal 21 with the larger surface area, so heat radiation is improved.

Also, as shown in FIG. 2, the distal ends of the lead terminals are mated with and fixed to a circuit board 22, allowing the light emitting unit 20 to be offset according to the angle α of inclination of the lead terminals. As a result, just as in Example 1, there is greater latitude in combining with other electronic devices, the size and weight of the apparatus are reduced, and its intensity becomes high.

### Example 3

As shown in FIG. 3, the light emitting unit 30 in this example has substantially the same constitution as the light emitting unit of Example 1, except that the first terminals of lead frames 32a, 32b, and 32c are angled not just at their distal end, but over their entire length at an inclination angle β of 40° with respect to the bottom fact 13a of the molded package.

With this configuration, just as in Example 1, the light emitting unit 30 can be offset according to the inclination angle β of the lead terminals, so there is greater latitude in combining with other electronic devices, the size and weight of the apparatus are reduced and its intensity becomes high.

This application claims priority to Japanese Patent Application Nos.2006-101516 and 2006-104977. The entire disclosure of Japanese Patent Application Nos.2006-101516 and 2006-104977 are hereby incorporated herein by reference.

While only selected embodiments have been chosen to illustrate the present invention, it will be apparent to those skilled in the art from this disclosure that various changes and modifications can be made herein without departing from the scope of the invention as defined in the appended claims. Furthermore, the foregoing descriptions of the embodiments according to the present invention are provided for illustration only, and not for the purpose of limiting the invention as defined by the appended claims and their equivalents. Thus, the scope of the invention is not limited to the disclosed embodiments.

## Claims

1. A light emitting unit (10; 20; 30), comprising:
a light emitting element (15a, 15b, 15c);
a plurality of lead frames (11, 12a, 12b, 12c) to which said light emitting element is electrically connected, each lead frame (11, 12a, 12b, 12c) having a first terminal with a distal end for insertion into a circuit board (22); and
a package (13) in which said lead frames are inserted so that at least the first terminal of each lead frame protrudes from a bottom side face (13a) of the package (13), and on which a light emitting window (14) is arranged through which light from the light emitting element is emitted,
the light emitting unit (10; 20; 30) being of a type configured to emit light from the light emitting window (14) in a direction which is substantially parallel to the plane of the circuit board (22) into which the distal ends of the first terminals are to be inserted;
wherein:
at least the distal end of each first terminal is inclined with respect to a side of the light emitting window (14);
**characterised in that** at least the distal end of each first terminal is also inclined with respect to the said bottom side face (13a) of the package (13) from which the first terminals protrude.

2. The light emitting unit according to Claim 1, wherein a second terminal of each lead frame protrudes from a different face of the package (13) than the bottom side face (13a) from which the first terminal of the lead frame of the package protrudes, and said second terminal has a larger surface area than said first terminal.

3. The light emitting unit according to Claim 1 or 2, wherein one side of the package (13) is parallel or perpendicular to one side of the light emitting window (14).

4. The light emitting unit according to Claim 1, 2 or 3, wherein the inclination angle is within a range of less than ±90°.

5. The light emitting unit according to any preceding Claim, wherein the side of the light emitting window (14) is disposed parallel to the bottom side face (13a) of the package (13).

6. The light emitting unit according to any preceding Claim, wherein the angle between the bottom side face (13a) of the package (13) and portions of the lead frames (11, 12a, 12b, 12c) immediately adjacent thereto is substantially 90°.

7. A lighting apparatus, comprising:
the light emitting unit (10; 20; 30) according to any preceding Claim;
a circuit board (22) into which the first terminals of the lead frames are inserted; and
a light guide plate that is disposed substantially parallel with the circuit board (22) and to one or both ends of which the light emitting window (14) is fixed.

## Patentansprüche

1. Licht emittierende Einheit (10; 20; 30), umfassend:
ein Licht emittierendes Element (15a, 15b, 15c);
mehrere Leiterrahmen (11, 12a, 12b, 12c) mit denen das Licht emittierende Element elektrisch verbunden ist, wobei jeder Leiterrahmen (11, 12a, 12b, 12c) einen ersten Anschluss mit einem distalen Ende zur Einführung in eine Leiterplatte (22) aufweist; und
ein Paket (13), in das die Leiterrahmen eingeführt sind, sodass mindestens der erste Anschluss jedes Leiterrahmens von einer Unterseitenfläche (13a) des Pakets (13) vorsteht, und auf dem ein Licht emittierendes Fenster (14) angeordnet ist, durch das Licht vom Licht emittierenden Element emittiert wird,
wobei die Licht emittierende Einheit (10; 20; 30) von einem Typ ist, der konfiguriert ist, Licht von dem Licht emittierenden Fenster (14) in einer Richtung zu emittieren, die im Wesentlichen parallel zur Ebene der Leiterplatte (22) ist, in welche die distalen Enden von den ersten Anschlüssen einzuführen sind;
wobei:
mindestens das distale Ende jedes ersten Anschlusses in Bezug auf eine Seite des Licht emittierenden Fensters (14) geneigt ist;
**dadurch gekennzeichnet, dass** mindestens das distale Ende jedes ersten Anschlusses auch in Bezug auf die Unterseitenfläche (13a) des Pakets (13) geneigt ist, von dem die ersten Anschlüsse vorstehen.

2. Licht emittierende Einheit nach Anspruch 1, wobei ein zweiter Anschluss jedes Leiterrahmens von einer Fläche des Pakets (13) vorsteht, die sich von der Unterseitenfläche (13a), von welcher der erste Anschluss des Leiterrahmens des Pakets vorsteht, unterscheidet, und der zweite Anschluss eine größere Fläche aufweist als der erste Anschluss.

3. Licht emittierende Einheit nach Anspruch 1 oder 2, wobei eine Seite des Pakets (13) parallel oder senkrecht zu einer Seite des Licht emittierenden Fensters (14) ist.

4. Licht emittierende Einheit nach Anspruch 1, 2 oder 3, wobei der Neigungswinkel innerhalb eines Bereichs von kleiner als ±90° liegt.

5. Licht emittierende Einheit nach einem der vorstehenden Ansprüche, wobei die Seite des Licht emittierenden Fensters (14) parallel zur Unterseitenfläche (13a) des Pakets (13) angeordnet ist.

6. Licht emittierende Einheit nach einem der vorstehenden Ansprüche, wobei der Winkel zwischen der Unterseitenfläche (13a) des Pakets (13) und Abschnitten der Leiterrahmen (11, 12a, 12b, 12c), die unmittelbar daran angrenzen, im Wesentlichen 90° beträgt.

7. Beleuchtungsvorrichtung, umfassend:
die Licht emittierende Einheit (10; 20; 30) nach einem der vorstehenden Ansprüche;
eine Leiterplatte (22), in welche die ersten Anschlüsse der Leiterrahmen eingeführt sind; und
eine Lichtleiterplatte, die im Wesentlichen parallel zur Leiterplatte (22) angeordnet ist, und an deren einem oder an deren beiden Enden das Licht emittierende Fenster (14) befestigt ist.

## Revendications

1. Unité électroluminescente (10 ; 20 ; 30), comprenant :
un élément électroluminescent (15a, 15b, 15c) ;
une pluralité de grilles de connexion (11, 12a, 12b, 12c) auxquelles ledit élément électroluminescent est électriquement connecté, chaque grille de connexion (11, 12a, 12b, 12c) comprenant une première borne dotée d'une extrémité distale pour l'insertion dans une carte de circuit imprimé (22) ; et
un boîtier (13) dans lequel lesdites grilles de connexion sont insérées de sorte qu'au moins la première borne de chaque grille de connexion fasse saillie à partir d'une face latérale inférieure (13a) du boîtier (13), et sur lequel une fenêtre électroluminescente (14) est agencée à travers laquelle la lumière provenant de l'élément électroluminescent est émise,
l'unité électroluminescente (10 ; 20 ; 30) étant d'un type configuré pour émettre de la lumière à partir de la fenêtre électroluminescente (14) dans une direction qui est sensiblement parallèle au plan de la carte de circuit imprimé (22) dans laquelle les extrémités distales des premières bornes doivent être insérées ;
dans laquelle ;
au moins l'extrémité distale de chaque première borne est inclinée par rapport à un côté de la fenêtre électroluminescente (14) ;
**caractérisée en ce que**
au moins l'extrémité distale de chaque première borne est également inclinée par rapport à ladite face latérale inférieure (13a) du boîtier (13) à partir de laquelle les premières bornes font saillie.

2. Unité électroluminescente selon la revendication 1, dans laquelle une seconde borne de chaque grille de connexion fait saillie à partir d'une face du boîtier (13) différente de la face latérale inférieure (13a) à partir de laquelle la première borne de la grille de connexion du boîtier fait saillie, et ladite seconde borne présente une surface active supérieure à celle de ladite première borne.

3. Unité électroluminescente selon la revendication 1 ou 2, dans laquelle un côté du boîtier (13) est parallèle ou perpendiculaire à un côté de la fenêtre électroluminescente (14).

4. Unité électroluminescente selon la revendication 1, 2 ou 3, dans laquelle l'angle d'inclinaison est compris dans une plage inférieure à +/- 90°.

5. Unité électroluminescente selon l'une quelconque des revendications précédentes, dans laquelle le côté de la fenêtre électroluminescente (14) est disposé parallèle à la face latérale inférieure (13a) du boîtier (13).

6. Unité électroluminescente selon l'une quelconque des revendications précédentes, dans laquelle l'angle entre la face latérale inférieure (13a) du boîtier (13) et des parties des grilles de connexion (11, 12a, 12b, 12c) immédiatement adjacentes à celle-ci est sensiblement égal à 90°.

7. Appareil d'éclairage, comprenant :
l'unité électroluminescente (10 ; 20 ; 30) selon une quelconque revendication précédente ;
une carte de circuit imprimé (22) dans laquelle les premières bornes des grilles de connexion sont insérées ; et
une plaque de guidage de lumière qui est disposée sensiblement parallèle à la carte de circuit imprimé (22) et à l'/aux extrémité(s) de laquelle la fenêtre électroluminescente (14) est fixée.
